(19) Europäisches Patentamt / European Patent Office / Office européen des brevets

(11) **EP 1 403 913 B1**

(12) **EUROPEAN PATENT SPECIFICATION**

(45) Date of publication and mention
of the grant of the patent:
**23.04.2008  Bulletin 2008/17**

(51) Int Cl.:
**H01L 21/324** *(2006.01)*     **H01L 21/00** *(2006.01)*
**H01L 21/30** *(2006.01)*     **H01L 21/32** *(2006.01)*

(21) Application number: **02743801.9**

(22) Date of filing: **03.07.2002**

(86) International application number:
**PCT/JP2002/006737**

(87) International publication number:
**WO 2003/005435 (16.01.2003 Gazette 2003/03)**

(54) **SUBSTRATE TREATING DEVICE AND SUBSTRATE TREATING METHOD**

SUBSTRATBEHANDLUNGSEINRICHTUNG UND SUBSTRATBEHANDLUNGSVERFAHREN

DISPOSITIF DE TRAITEMENT DE SUBSTRAT ET PROCEDE DE TRAITEMENT DE SUBSTRAT

(84) Designated Contracting States:
**FR IT**

(30) Priority: **05.07.2001   JP 2001205171**

(43) Date of publication of application:
**31.03.2004   Bulletin 2004/14**

(73) Proprietors:
• **Ohmi, Tadahiro**
  **Sendai-shi,**
  **Miyagi-ken 980-0813 (JP)**
• **TOKYO ELECTRON LIMITED**
  **Tokyo-to (JP)**

(72) Inventors:
• **OHMI, Tadahiro**
  **Sendai-Shi,**
  **Miyagi 980-0813 (JP)**
• **SUGAWA, Shigetoshi,**
  **Tohoku University**
  **Sendai-Shi, Miyagi 980-8579 (JP)**
• **HIRAYAMA, Masaki,**
  **Ind. Creation Hatchery Ctr.Tohoku Univ.**
  **Sendai-Shi,**
  **Miyagi 980-8579 (JP)**
• **GOTO,Tetsuya,**
  **New Ind. Creation Hatchery Ctr.Tohoku Univ.**
  **Sendai-Shi,**
  **Miyagi 980-8579 (JP)**

(74) Representative: **Liesegang, Roland**
**FORRESTER & BOEHMERT**
**Pettenkoferstrasse 20-22**
**80336 München (DE)**

(56) References cited:
EP-A1- 0 614 216        JP-A- 5 000 801
JP-A- 6 338 491         JP-A- 7 235 534
JP-A- 10 340 857        JP-A- 63 040 314
JP-A- 2000 031 109      JP-A- 2000 216 165
JP-A- 2001 049 437      JP-A- 2001 131 741
US-A- 6 086 679

• **PATENT ABSTRACTS OF JAPAN vol. 2000, no. 11, 3 January 2001 (2001-01-03) & JP 2000 216165 A (FUJITSU LTD), 4 August 2000 (2000-08-04)**
• **PATENT ABSTRACTS OF JAPAN vol. 2000, no. 08, 6 October 2000 (2000-10-06) -& JP 2000 133806 A (SONY CORP), 12 May 2000 (2000-05-12)**
• **PATENT ABSTRACTS OF JAPAN vol. 2000, no. 04, 31 August 2000 (2000-08-31) -& JP 2000 031109 A (OMI TADAHIRO; URUTORA CLEAN TECHNOL KAIHATSU KENKYUSHO:KK), 28 January 2000 (2000-01-28)**
• **'Cat-CVD ho ni yoru handotai device seizo process seika hokokukai shiryo' 04 June 2001, pages 21 - 24, XP002966389**
• **AKIRA HEYA ET AL.: 'Low-temperature crystallization of amorphous silicon using atomic hydrogen generated by catalytic reaction on heated tungsten' APPL. PHYS. LETT. vol. 74, no. 15, 12 April 1999, pages 2143 - 2145, XP002956400**

EP 1 403 913 B1

**Description**

TECHNICAL FIELD

The present invention generally relates to fabrication of a semiconductor device, particularly, to hydrogen termination processing for a semiconductor substrate and a hydrogen termination apparatus.

BACKGROUND OF THE INVENTION

In a semiconductor fabrication process, at the final step, a silicon substrate or a glass substrate formed with various semiconductor devices is heat-treated at a temperature of 400 °C in a hydrogen atmosphere, this being the so-called hydrogen sinter processing. Due to the hydrogen sinter processing, dangling bonds dominant in the interfacial region between the silicon substrate and an oxide film, or dangling bonds in a poly-silicon film or an amorphous silicon film are terminated, and charges are captured by the dangling bonds, so change of the characteristics of a semiconductor device is suppressed.

In the related art, by the aforesaid heat treatment in a hydrogen atmosphere, the hydrogen sinter processing is performed by supplying hydrogen molecules to the interface between the silicon substrate and the oxide film. On the other hand, in a so-called sub-quarter micron device, that is, a highly miniaturized semiconductor device having a gate less than 0.1 $\mu$m, instead of a conventional thermal oxide film, it has been studied to make use of a nitride film or a nitride oxide film formed by plasma direct nitridization or plasma direct nitridization and oxidation or plasma CVD as a gate insulating film or various other parts. However, in a highly miniaturized semiconductor device utilizing such a nitride film or a nitride oxide film, it is difficult for the hydrogen molecules to pass through the nitride film or nitride oxide film of a high density, hence, it is predicted that the conventional hydrogen sinter processing will not work effectively.

In addition, for a semiconductor device, such as a thin film transistor (TFT), in which the active region is formed by an amorphous silicon film or a poly-silicon film made on a glass substrate, it has also been studied to make use of a nitride film or a nitride oxide film formed by plasma direct nitridization or plasma direct nitridization and oxidation or plasma CVD as a gate insulating film, but, also in this case, it becomes difficult to terminate the dangling bonds in a poly-silicon film or an amorphous silicon film, or the dangling bonds on the interface between the poly-silicon film or the amorphous silicon film with the insulating film by means of hydrogen sinter processing.

In the related art, when a semiconductor device fabrication process is started, a semiconductor substrate such as a silicon wafer is exposed to $H_2$ gas at a temperature of 1200 °C, and thereby the unevenness of the surface is eliminated. In detail, the $H_2$ gas acts on the substrate surface, and a $SiH_4$ gas is generated, and as a result, projecting portions on the substrate surface are smoothed. However, since a temperature of 1200 °C is quite high a temperature, it is difficult to perform planarization uniformly over the entire substrate surface, especially for a substrate of large diameter. In practice, in a planarization process, it turns out to be necessary to realize a uniform temperature distribution with a precision of 1200 $\pm$ 1 °C. In view of using the most recent large diameter substrates, it is desirable to lower the temperature for planarization processing to about 800 °C. In substrate processing of the related art using $H_2$ molecules, it is difficult to perform the desired planarization processing at such a low temperature.

A substrate processing apparatus according to the preamble of claim 1 is known from JP 2000 216165 A and JP 2000 031109 A.

DISCLOSURE OF THE INVENTION

Accordingly, a general object of the present invention is to provide a novel and useful substrate processing apparatus and a method for fabricating a semiconductor device able to solve the above problems according to claims 1 and 21.

A more specific object of the present invention is to provide a substrate processing apparatus for terminating dangling bonds on the surface of a semiconductor substrate by using hydrogen radicals, and a method for fabricating a semiconductor device including dangling bond termination processing by using the above hydrogen radicals.

Another object of the present invention is to provide a substrate processing apparatus characterized by comprising a processing space provided with a holding stand for holding a substrate to be processed, a hydrogen catalyzing member arranged in said processing space to face said substrate and for decomposing hydrogen molecules into hydrogen radicals H*, and a gas feeding port arranged in said processing space on an opposite side of the hydrogen catalyzing member to said substrate and for feeding a processing gas including at least hydrogen gas, wherein an interval between said hydrogen catalyzing member and said substrate on said holding stand is set less than the distance that said hydrogen radicals H* can reach.

Still another object of the present invention is to provide a substrate processing method characterized by comprising a step of feeding hydrogen gas as a processing gas to a processing chamber, a step of activating said hydrogen gas with a hydrogen catalyst and generating hydrogen radicals H*, a step of making said hydrogen radicals flow to a substrate to be processed, and a step of processing said substrate using said hydrogen radicals H*.

Yet another object of the present invention is to provide a substrate processing method characterized by comprising a step of feeding hydrogen gas as a processing gas to a processing chamber, a step of activating said hydrogen gas with a hydrogen catalyst and generating hydrogen radicals H*, a step of making said hydrogen radicals flow to a substrate to be processed, and a step of planarizing said substrate using said hydrogen radicals H*, wherein the step of planarizing said substrate is carried out at a temperature not higher than 800 °C.

BRIEF DESCRIPTION OF THE DRAWINGS

Fig. 1 is a view showing a configuration of a substrate processing apparatus according to a first embodiment of the present invention;

Figs. 2A and 2B are views showing a configuration of a catalytic filter used in the substrate processing apparatus in Fig. 1;

Fig. 3 is a view showing a result of a relation between the hydrogen radical generation efficiency and the catalyst temperature obtained by water generation in the substrate processing apparatus in Fig. 1;

Fig. 4 is a view showing a concentration distribution of hydrogen radicals in a region just below a catalytic filter in terms of flux in the substrate processing apparatus in Fig. 1;

Fig. 5 is a view showing a relation of required structure parameters, hydrogen concentration in the processing gas, and processing time for obtaining a sufficient amount of hydrogen radicals for substrate processing in the substrate processing apparatus in Fig. 1;

Fig. 6 is a view showing distributions of elements in a catalytic metal film before being used in a catalytic reaction;

Fig. 7 is a view showing distributions of elements in a catalytic metal film after being used in a catalytic reaction;

Fig. 8 is another view showing distributions of elements in a catalytic metal film after being used in a catalytic reaction;

Fig. 9 is yet another view showing distributions of elements in a catalytic metal film after being used in a catalytic reaction;

Figs. 10A and 10B are views showing a configuration of a catalyzing member according to a second embodiment of the present invention;

Fig. 11 is a view showing a configuration of a catalyzing member according to a modification to the second embodiment of the present invention;

Fig. 12 is a view showing a configuration of a substrate processing apparatus according to a third embodiment of the present invention;

Fig. 13 is a view showing a configuration of a substrate processing apparatus according to a fifth embodiment of the present invention; and

Fig. 14 is a view showing a surface of a glass substrate processed by the substrate processing apparatus in Fig. 2.

BEST MODE FOR CARRYING OUT THE INVENTION

[Principle]

Using hydrogen radicals H* (hydrogen atoms), the present invention terminates the dangling bonds generated in an insulating film, such as a nitride film or a nitride oxide film, covering a silicon substrate or a glass substrate, and especially on the interface between the insulating film and the substrate, or in a poly-silicon film or an amorphous silicon film. Hydrogen radicals H* are able to pass through the nitride film or the nitride oxide film.

Hydrogen radicals H* can be easily generated, for example, by exciting hydrogen molecules in He plasma, but because the collision cross section of He is small in the He plasma, the electron temperature is very high, and for this reason, there arises a problem that both a silicon substrate and the sidewall of a processing chamber of a substrate processing apparatus for performing hydrogen termination are sputtered and damaged.

In order to avoid the above problem, in the present invention, the hydrogen radicals H* are generated by a reaction using the catalytic effect of metals:

$$H_2 \rightarrow H^* + H^*$$

In this case, since the lifetime of the generated hydrogen radicals H* is short, the catalyst inducing the above reaction is placed near the substrate, in other word, at a distance within the recombination lifetime of the generated hydrogen radicals H*. As the catalyst, use is made of metals having large electron affinity, hence enabling decomposition of hydrogen molecules into hydrogen radicals H* by the above catalytic effect. On the other hand, it is preferable that an oxide film not be formed in metals used as catalysts, accordingly as the relevant metals, Ni, Pt, Pd, Ir, Au are preferably used. Further, in order to increase the distance that the hydrogen radicals H* can reach so as to improve freedom of design of the substrate processing apparatus, it is preferable that the hydrogen gas supplied to the processing chamber be diluted by inactive gases. Diluting the hydrogen gas reduces the possibility for the generated hydrogen radicals H* to recombine with each other and return to hydrogen molecules.

In addition, by using hydrogen radicals H* generated in this way for planarization of the surface of a silicon substrate or other semiconductor substrates, the temperature of the substrate planarization processing can be lowered from 1200 °C in the related art up to not higher than 800 °C.

By providing a diffusion barrier formed from TiN, TaN, WN or other nitrides between a metal catalyzing layer comprised of catalytic metals exhibiting catalysis, and a carrier holding the metal catalyzing layer, it is possible to suppress diffusion of the above catalytic metal elements from the above metal catalyzing layer to the carrier, and diffusion of metal elements from the carrier to the above metal catalyzing layer, even if the catalytic reaction is performed in an atmosphere including oxygen in addition to hydrogen, and thus it is possible to realize stable catalytic reactions. But such a diffusion barrier film can be omitted when the catalytic reactions are performed in an atmosphere not including oxygen.

[First Embodiment]

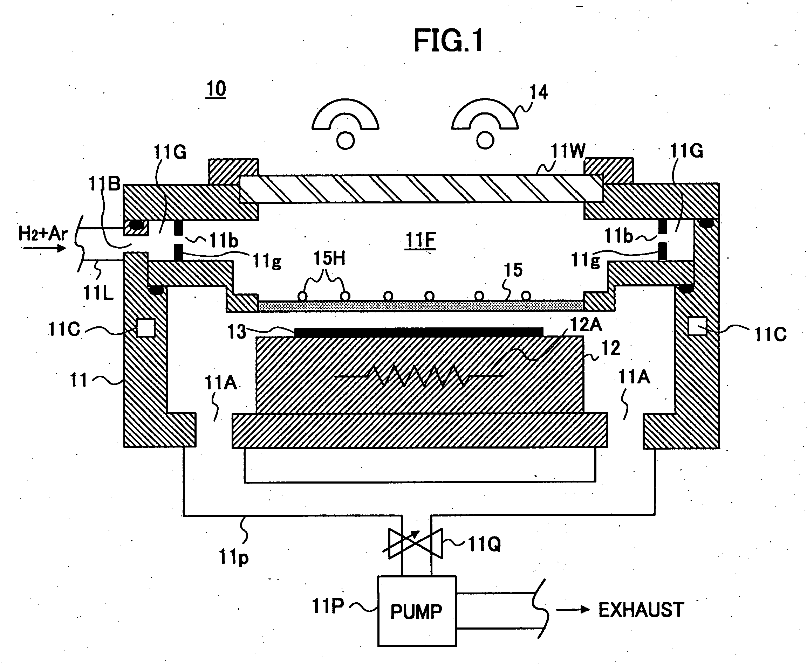

FIG. 1 shows a configuration of a substrate processing apparatus 10 for carrying out hydrogen sinter processing according to the first embodiment of the present invention.

Referring to FIG. 1, the substrate processing apparatus 10 is equipped with a processing chamber 11 exhausted at exhaust ports 11A by a pump 11P, and a substrate 13 to be processed is held on a stage 12 in the processing chamber 11. The exhaust ports 11A and the stage 12 are provided on the bottom of the processing chamber 11. On the top of the processing chamber 11, a transparent optical window 11W is provided, and lamp heating devices 14 are provided adjacent to the optical window 11W. In addition, a heating device 12A for heating the substrate to be processed is provided in the stage 12

A gas line 11L extended from an external gas source is connected at the upper part of the sidewall of the processing chamber 11. The gas line 11L is equipped with a feed port 11B for feeding as a processing gas the supplied hydrogen gas together with Ar or other carrier gases to the processing chamber 11. The processing gas fed from the feed port 11B fills a gas channel 11G formed along the inner periphery of the sidewall; and then is emitted uniformly to the inside of the processing chamber 11 through openings 11b formed on an inner partition wall 11g that defines the gas channel 11G in the processing chamber 11. The openings 11b are uniformly formed on the inner partition wall 11g, that is, the inner partition wall 11g functions as a shower plate

The processing gas emitted through the shower plate 11g fills the space 11F beside the optical window 11W in the processing chamber 11, and by driving the pump 11P, the processing gas flows to the surface of the substrate 13 through a hydrogen catalytic filter 15 that serves as the lower end of the space 11F. At this time, by setting the gas pressure at the exhaust ports 11A lower than atmospheric pressure, a uniform gas flow to the surface of the substrate 13 can be formed. On the hydrogen catalytic filter 15, a temperature controlling device 15H is provided.

So, by driving the lamp heating device 14 and the temperature controlling device 15H, and setting the temperature of the filter 15 to a desired value, due to a Pt catalyst in the filter 15, a decomposition reaction of the hydrogen content expressed by $H_2 \rightarrow H^* + H^*$ takes place in the processing gas flowing to the surface of the substrate 13 from the space 11F, and hydrogen atoms, as well as hydrogen radicals $H^*$ are generated. The temperature of the substrate 13 is set to, for example, 400 °C by the heater 12A in the stage 12.

The hydrogen radicals $H^*$ generated in this way pass through the insulating film formed on the surface of the substrate 13, and terminate the dangling bonds generated on the interface of the substrate and the insulating film, or inside the insulating film. The hydrogen radicals $H^*$ can freely pass through the insulating film, no matter whether the insulating film is an oxide film or a nitride film or a nitride oxide film.

In the configuration in FIG. 1, the pipe 11p connected to exhaust ports 11A is in communication with the pump 11P through a valve 11Q, and the processing gas passing through the surface of the substrate 13 is discharged to the outside from the exhaust ports 11A through the pipe 11p by the pump 11P. Further, in the configuration of FIG. 1, a cooling water channel 11C is formed inside the sidewall of the processing chamber 11. The temperature controlling device 15H as described above is provided in the filter 15. As an example, the temperature controlling device 15H forms a channel of a heat exchange medium, and maintains.the filter 15 at a predetermined temperature.

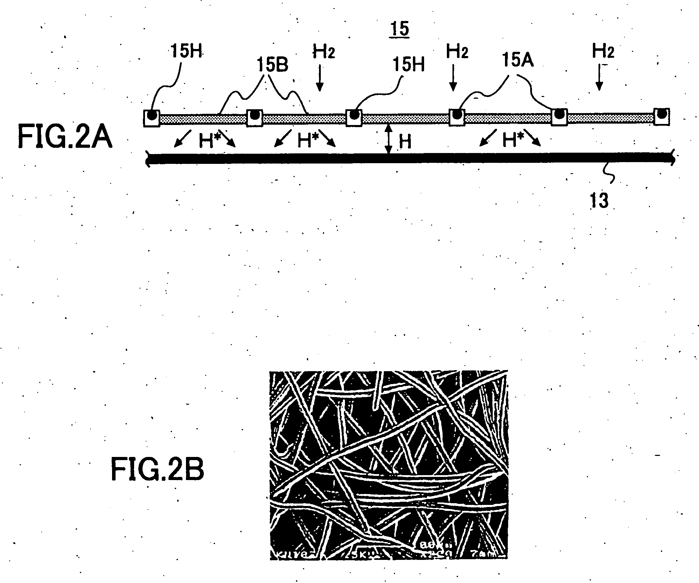

FIG. 2A shows a configuration of the filter 15.

Making reference to FIG. 2A, the filter 15 includes a grid-like frame member 15A and a porous filter 15B held by the frame member 15A, and the temperature controlling device 15H is formed on the frame member 15A.

The porous filter 15B is comprised of sintered stainless steel wires, and a Pt film is deposited on a surface of each stainless steel wire with a TiN diffusion barrier layer in between.

FIG. 2B presents a picture taken by a scanning electron microscope showing the structure of the porous filter 15B.

Referring to FIG. 2B, the porous filter 15B is shown to be an aggregation of a large number of stainless steel wires, and there is room between the wires allowing the processing gas including the hydrogen gas and the inactive gas to pass through.

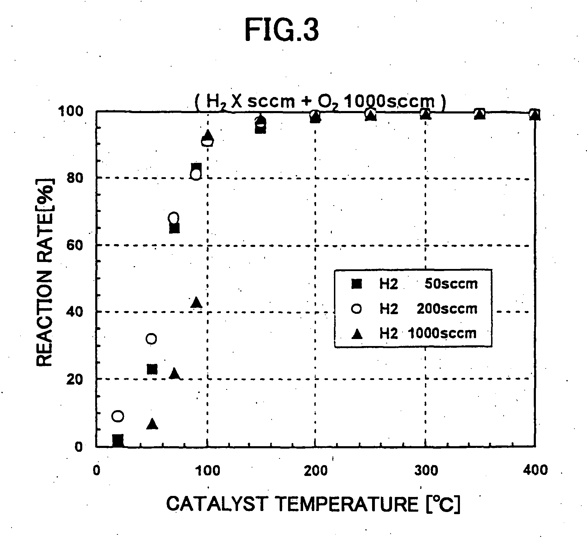

FIG. 3 shows results of measured generation efficiencies of the hydrogen radicals $H^*$ in the catalytic filter 15 in the substrate processing apparatus 10, obtained by feeding a mixture of oxygen gas and hydrogen gas from the gas feed port 11B and further measuring the water content in the discharged gas in the exhaust pipe 11p. If the generation efficiency of the hydrogen radicals $H^*$ in the filter 15 is low, the amount of the water content observed in the pipe 11p decreases, in contrast, if the generation efficiency of the hydrogen radicals $H^*$ in the filter 15 is high, the amount of the water content observed in the pipe 11p increases. Accordingly, the amount of the water content observed in the pipe 11p can be viewed as an indicator of the generation efficiency of the hydrogen radicals H*. Note that in the experiment shown in FIG. 3, the silicon substrate 13 is not set in the processing chamber 11.

Making reference to FIG. 3, the ordinate axis represents the reaction rate of the reaction $H_2 + 1/2 O_2 -> H_2O$, and the abscissas axis represents the temperature of the filter 15. In the experiment shown in FIG. 3, the oxygen gas was fed at a flow rate of 1000 sccm, while the flow rate of the hydrogen gas was set to various values changing in a range from 50 sccm to 1000 sccm.

Referring to FIG. 3, although the flow rate of the hydrogen gas was changed greatly, it is found that in all cases the reaction rate rises abruptly with the temperature changing in a range from the room temperature to 100 °C indicated by the filter 15, and it reaches 90% at 100 °C, and at 200°C, a reaction rate of 98% to 100% is obtainable.

The results shown in FIG. 3 reveal that hydrogen radicals H* are efficiently generated by using the Pt filter 15 at a filter temperature of 100 °C or higher, preferably, 200 °C or higher.

Meanwhile, the hydrogen radicals H* generated in this way return to hydrogen gas $H_2$ if they collide with each other. So, if the distance H between the filter 15 and the substrate 13 (FIG. 2A) is too long, the generated hydrogen radicals H* disappear along the way, and fail to arrive at the surface of the substrate 13. The distance H that the hydrogen radicals H* can reach, that is, the range of the hydrogen radicals H*, depends on the concentration of the hydrogen radicals H* in the space between the filter 15 and the substrate 13, and it decreases if the concentration of the hydrogen radicals H* is high. Due to this, the concentration of the hydrogen radicals H* exponentially decays with the distance from the filter 15 towards the substrate 13 measured from exactly just below the filter 15. From this fact, it is considered that it is preferable that the hydrogen gas fed into the processing chamber 11 from the feed port 11B be diluted to a certain degree by Ar or other inactive gases.

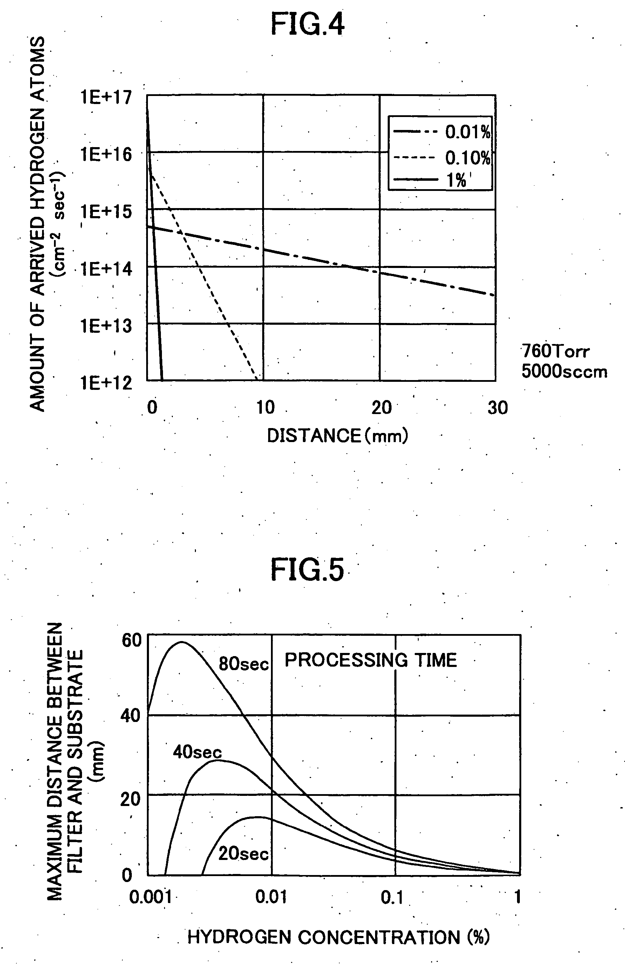

FIG. 4 shows a concentration distribution of hydrogen radicals H* in a direction from just below the filter 15 towards the surface of the substrate 13, in a case that hydrogen gas diluted by Ar gas is supplied as a processing gas to the processing chamber. 11 from the feed port 11B. In the experiment shown in FIG. 4, the concentration of the hydrogen gas in the processing gas was set to 0.01%, 0.1% and 1%, respectively. In FIG. 4, the ordinate axis shows the concentration of hydrogen radicals H* in term of flux of the hydrogen radicals H* per unit time and per unit area, and the abscissas axis shows the distance measured from the lower surface of the filter 15 towards the substrate 13.

Referring to FIG. 4, when the concentration of the hydrogen gas in the processing gas is 1%, corresponding to the high concentration of the hydrogen gas, a very high concentration of hydrogen radicals H* over $1 \times 10^{16}$ cm$^{-2}$ sec$^{-1}$ in term of radical flux is obtained just below the.filter 15, but due to the high possibility of recombination according to the high concentration of hydrogen radicals H*, the lifetime of hydrogen radicals H* become extremely short, so the concentration of hydrogen radicals H* drops sharply with the distance. In contrast, when the concentration of the hydrogen gas in the supplied processing gas is 0.01%, the lifetime of the generated hydrogen radicals H* is long, and a radical flux of $1 \times 10^{13}$ cm$^{-2}$ sec$^{-1}$ is obtained even at a position 30 mm away from the lower surface of the filter 15. Meanwhile, the radical flux is lower than $1 \times 10^{15}$ cm$^{-2}$ sec$^{-1}$ just below the filter 15. When the concentration of the hydrogen gas in the supplied processing gas is 0.1%, an intermediate radical flux between the above two cases is obtained.

FIG. 5 presents results of the relation between the permitted maximum filter-substrate distance H and the hydrogen concentration, associated with various processing times, obtained when supplying, per unit area, the silicon substrate 13 in FIG. 1 with hydrogen radicals H* of an amount greater than the area atomic density $(2.7 \times 10^{15}$ cm$^{-2})$ of silicon on the surface of a silicon crystal.

Referring to FIG. 5, it is found that when the hydrogen concentration in the processing gas is higher than 0.1%, irrespective of the processing time, the catalytic filter 15 has to be brought to a distance not more than 5mm from the substrate 13, whereas, when the hydrogen concentration in the processing gas is less than 0.01%, by extending the processing time, it is possible to supply a sufficient amount of hydrogen radicals H* to terminate the dangling bonds of silicon atoms even though the distance H between the catalytic filter 15 and the substrate 13 is longer. For example, it is shown that by setting the hydrogen concentration in the processing gas to about 0.002%, and allowing a processing time of 80 seconds, the interval between the catalytic filter 15 and the substrate 13 can be increased up to 60 mm.

As shown above, in the substrate processing apparatus 10 in FIG. 1, it is possible to effectively terminate the dangling bonds on the interface of silicon and silicon dioxide on the substrate 13 by supplying as a processing gas hydrogen gas diluted with Ar or other inactive gases in the gas feed port 11B, and maintaining the catalytic filter 15 at a temperature higher than 100 °C, preferably higher than 200 °C, and further setting the distance H between the filter 15 and the substrate 13 to a most appropriate value not more than 60 mm according to the hydrogen concentration in the processing gas. The above substrate processing can be performed while setting the temperature of the substrate 13 lower than 400 °C, as a result; it is possible to avoid the problem of characteristics change in a highly-miniaturized semiconductor device formed on the processed substrate 13. On the other hand, since there arises a danger of hydrogen explosion when the temperature of the catalytic filter 15 is higher than 500 °C, it is desirable to control the temperature of the catalytic filter 15 not to exceed 550 °C.

In the substrate processing apparatus 10 in FIG. 1, since the hydrogen radicals H* are not generated by plasma processing, there is not the problem of ion irradiation damage of the highly-miniaturized semiconductor device on the silicon substrate or the processing chamber 11, even if the hydrogen radicals H* are generated.

In the above explanation, the hydrogen radicals H* were generated by the decomposition reaction of hydrogen molecules under the catalytic effect of Pt in the catalytic filter 15, but the catalyst is not limited to Pt, use may be made of metal elements that have large electron affinity, are able to effectively decompose hydrogen molecules ($H_2$) into hydrogen radicals H*, and can hardly be oxidized, that is, the entropy of oxide generation is large. Such metals include Pt, Ni, Pd, Ir, Au, and their alloys. Further, compounds of these metals and their alloys are also usable.

In addition, in the above explanation, an example is described of using a silicon substrate as the substrate 13 that is to be processed, but it is possible to use a glass substrate, for example, a glass substrate carrying a TFT, as the substrate 13 in the apparatus in FIG. 1.

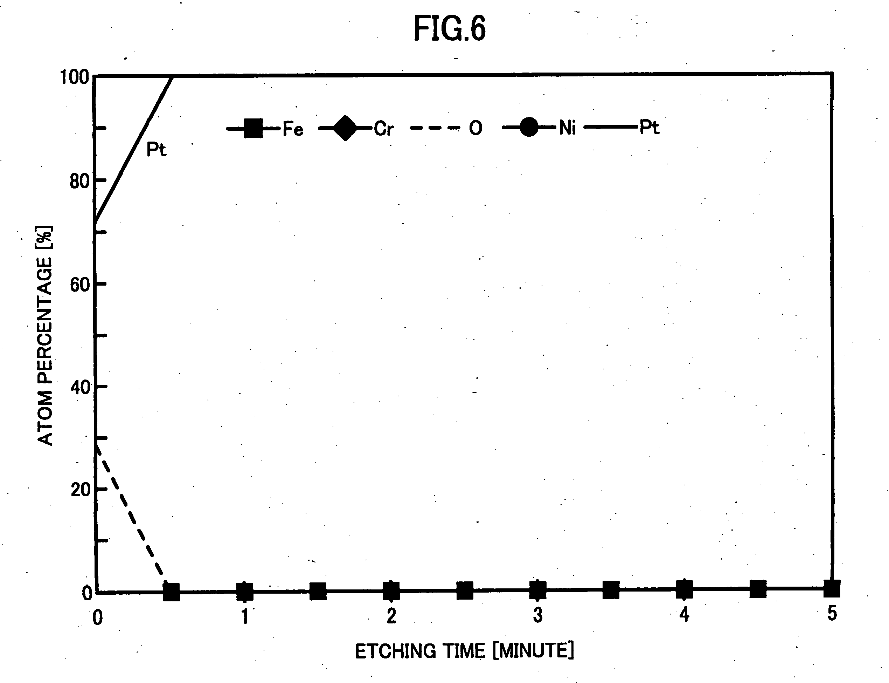

FIG. 6 shows results of element distributions along the depth direction in a Pt film in a state prior to usage as a catalyst, measured by means of ESCAR (Electron Spectroscopy For Chemical Analysis), when the Pt film is directly formed on the surface of a stainless steel wire without the aforesaid TiN diffusion barrier film in the porous filter 15 shown in FIGs. 2A and 2B. In FIG. 6, the ordinate indicates atom concentrations of elements in term of atom percentage, the abscissa indicates the etching time of Ar sputtering during the ESCAR analysis.

Making reference to FIG. 6, in the state prior to usage, except for a slight amount of oxygen atoms penetrating into a limited area of the film surface, the Pt film consisted of the Pt element only, and existence of any other elements is not observed.

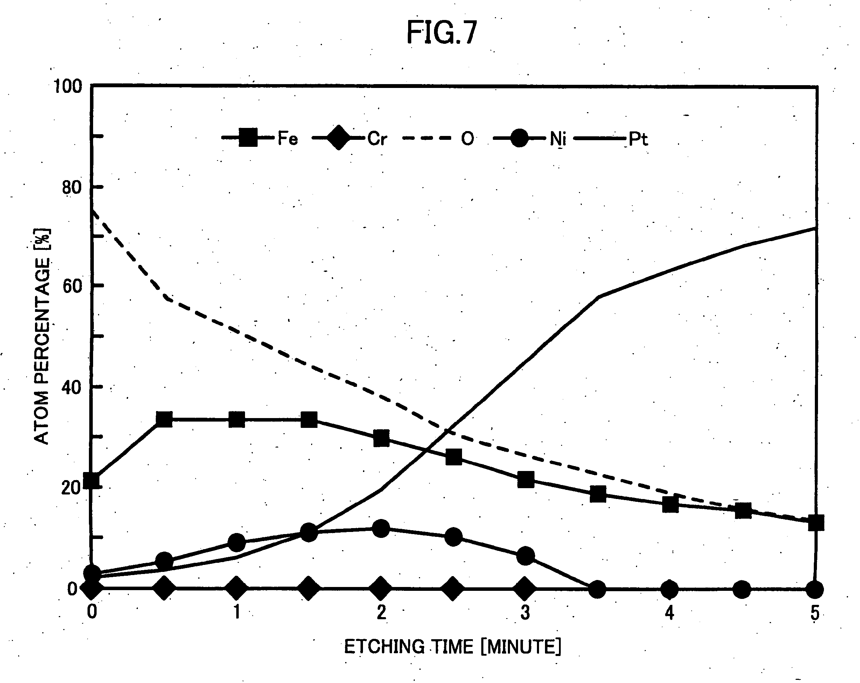

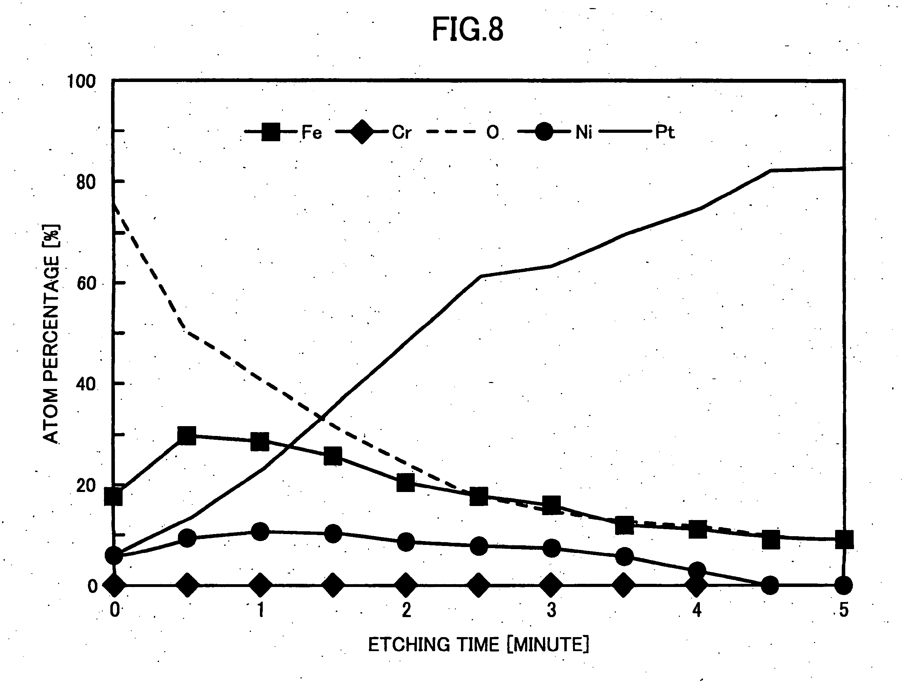

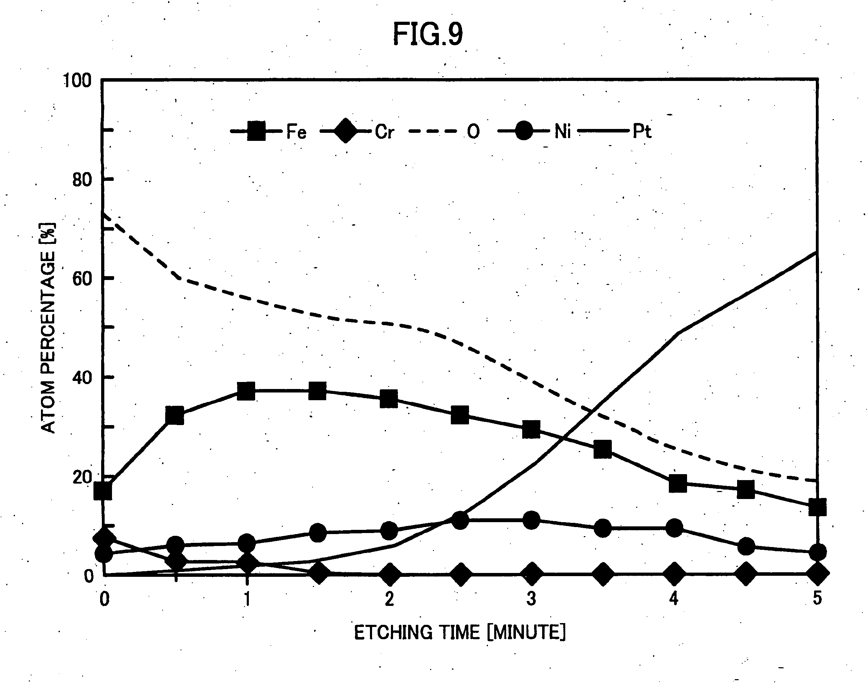

In contrast, FIGs. 7 through 9 show element distributions in the Pt film, when the Pt film was used for 663 hours in an atmosphere of mixed hydrogen gas and oxygen gas was supplied at flow rates of 2000 sccm for the $H_2$ gas and 1200 sccm for the $O_2$ gas, and with the porous filter 15 at a temperature of 485 °C. Note that FIG. 7 shows the analyzing results for a discolored golden outer portion of the filter 15, FIG. 8 shows the analyzing results for a discolored silver center portion of the filter 15, and FIG. 9 shows the analyzing results for a discolored golden inner portion of the filter 15.

Referring to FIGs. 7 through 9, it was found that, as shown by all of these analyzing results, after the usage, oxygen is strongly concentrated on the surface of the Pt film, and the concentrations of Fe, Cr, and Ni increase, in other words, on the surface of the Pt film, oxides of Fe, Cr, and Ni are formed. Since originally these elements did not exist in the Pt film, it is believed that they come from the stainless wire carrying the Pt film. In addition, since the concentration of Pt declines remarkably, it appears that in accordance with oxygen penetration, Pt atoms diffuse into the stainless steel wire.

In the present embodiment, such kind of metal element diffusion and Pt film erosion can be suppressed by interposing a TiN diffusion barrier film as previously described between the stainless steel wire and the Pt film.

In contrast, it is found that such kind of metal element diffusion is not observed and the element distributions shown in FIG. 6 remain unchanged even after filter 15 has been used, when using the porous filter 15 in an atmosphere of 100% hydrogen but no oxygen. In other words, it is possible to use a porous filter 15 with the Pt film formed on the stainless steel wire as an effective hydrogen catalytic filter in an atmosphere of 100% hydrogen. Of course, it is also possible to use a porous filter configured to have a TiN diffusion barrier layer as a hydrogen catalytic filter in an atmosphere of 100% hydrogen but no oxygen.

As such a diffusion barrier layer, besides TiN, various nitrides, for example TaN, or WN can be used.

[**Second Embodiment**]

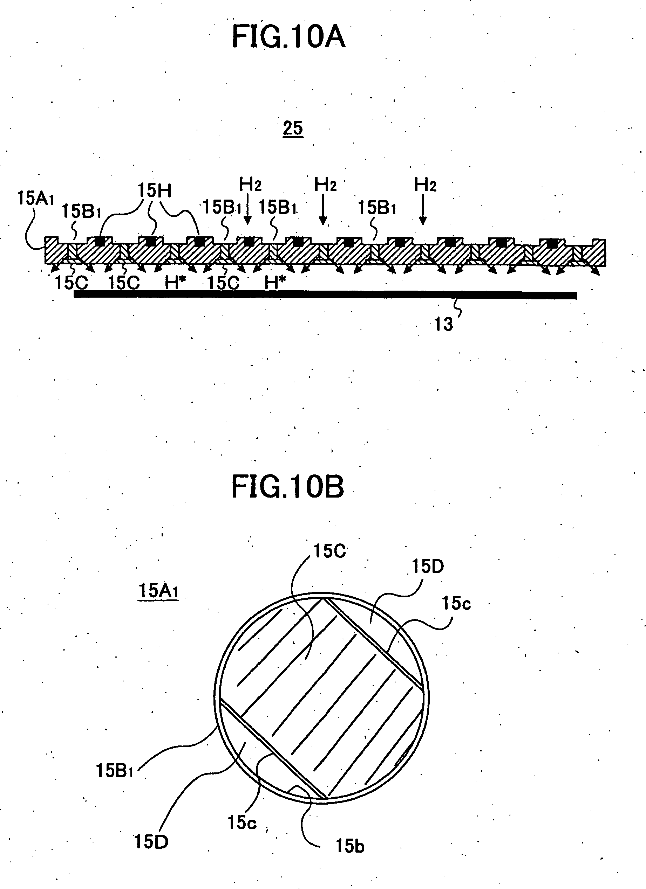

FIGs. 10A and 10B show a configuration of a catalyzing member 25 according to the second embodiment of the present invention, which is used in the substrate processing apparatus 10 in FIG. 1 as a substitute for the catalytic filter 15. In FIGs. 10A and 10B, the same reference numerals are assigned to the same parts that have already been described, and explanations thereof are omitted.

Making reference to FIG. 10A, the catalyzing member 25 includes a disk-shaped supporting member $15A_1$ made from metal or others, and in the supporting member $15A_1$, a large number of penetration holes $15B_1$ are formed.

As shown in detail in FIG. 10B, a catalytic film 15b comprised of Pt or others is coated on the inner surface of a penetration hole $15B_1$, furthermore, a plug 15C is inserted into the penetration hole $15B_1$. As shown in FIG. 10B, the plug 15C is partially cut on its side surfaces, so gas flowing channels 15D are formed between the plug 15C and the penetration hole $15B_1$. Furthermore, a catalytic film 15c comprised of Pt or others is also coated on a portion of the side surfaces of the plug 15C forming the channel 15D.

As shown in FIG. 10A, at the lower end of the plug 15C, that is, at the end facing the silicon substrate 13 on the holding stand 12, there is provided a diffusion portion having an enlarged diameter, accordingly, at the lower end of the penetration hole $15B_1$, there is formed a taper portion to accommodate the diffusion portion.

In the catalyzing member 25 of the above configuration, the hydrogen gas fed from the shower openings 11b in FIG. 1 is supplied through the gas channel 15D in the penetration hole $15B_1$ to the surface of the substrate 13, and in this period, the hydrogen gas is decomposed into hydrogen radicals H* due to the catalytic effect of the Pt films 15b and 15c. The hydrogen radicals H* generated in this way arrive at the surface of the substrate 13, and terminate the dangling bonds in the interface of silicon dioxide and silicon on the surface of the substrate 13.

In this embodiment, it is also preferable that the hydrogen gas be supplied as a processing gas after being diluted in inactive gases, and the interval between the catalyzing member 25 and the substrate 13 be set to not longer than 60 mm.

As the catalyzing films 15b and 15c, use can be made of the previously described Pt, Ni, Pd, Ir, Au, and their alloys, or compounds of these metals and their alloys.

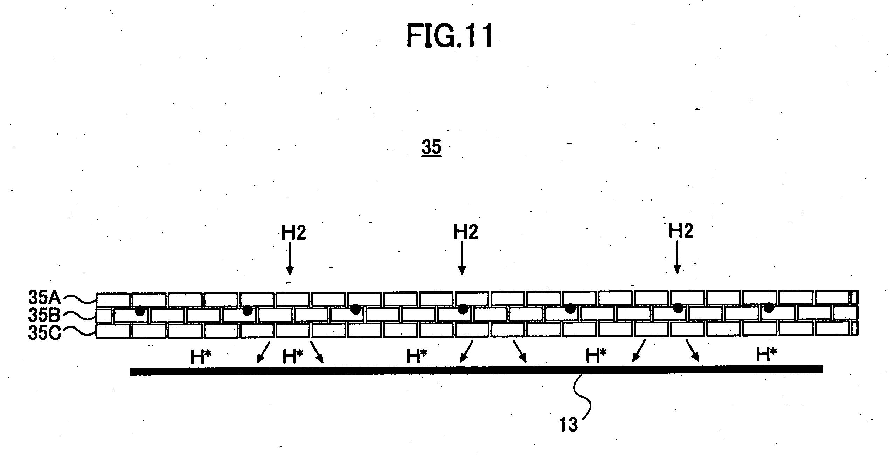

FIG. 11 shows a configuration of a catalyzing member according to a modification to the catalyzing member 25 in FIGs. 10A and 10B.

Referring to FIG. 11, the catalyzing member 35 has a stacked structure of the catalyzing members 35A through 35C each of which is a catalyzing member as shown in FIGs. 10A and 10B. The hydrogen gas passes through the catalyzing members 35A to 35C in order, and arrives at the surface of the substrate 13. In each of the catalyzing members 35A to 35C, a large number of the same penetration holes as described above are formed, and the hydrogen gas is decomposed into hydrogen radicals H* due to the catalyzing film when the hydrogen gas passes through the channels in the penetration holes.

### [Third Embodiment]

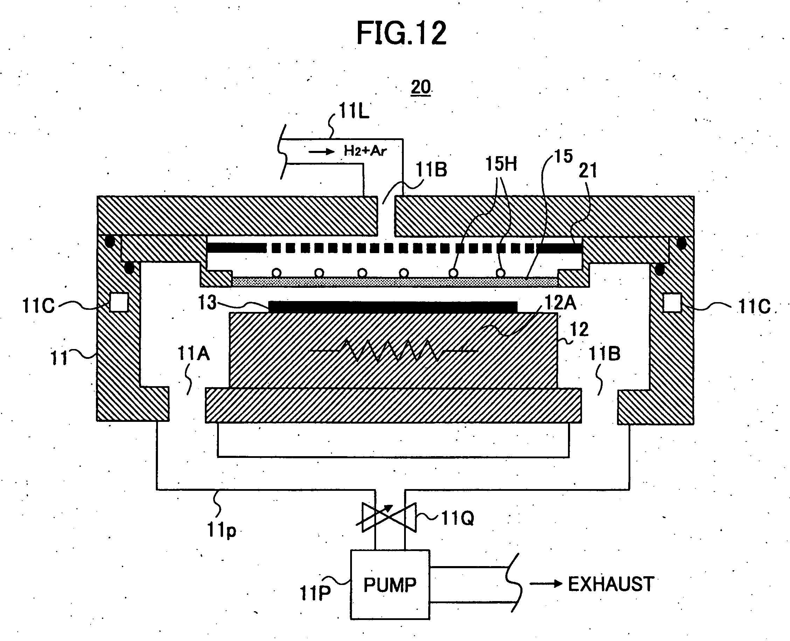

FIG. 12 shows a configuration of a substrate processing apparatus 20 according to the third embodiment of the present invention.

Referring to FIG. 12, in the substrate processing apparatus 20, the feed port 11B connected with the.gas line 11L is formed at the top of the processing chamber 11, and a shower head 21 is formed in the processing chamber 11 corresponding to the feed port 11B. So, the processing gas fed to the processing chamber 11 from the gas line 11L through the gas feed port 11B passes through the catalytic filter 15 and flows to the surface of the substrate 13, and the hydrogen radicals H* generated in the catalytic filter 15 terminate the dangling bonds on the surface of the substrate 13.

Note that in the present embodiment, the lamp 14 used for heating the filter in the apparatus in FIG. 1 is removed. Inside the holding stand 12, a heater 12A is provided to heat the substrate 13.

### [Fourth Embodiment]

The substrate processing apparatus in FIG. 1 or in FIG. 12 can be used not only for dangling bond termination on the surface of a semiconductor substrate on which a semiconductor device has already been formed, but also for planarizing a semiconductor substrate at a higher temperature. As shown before, planarization of a semiconductor substrate is performed prior to a fabrication progress of a semiconductor device, and in the related art, projecting portions on the substrate surface are planarized by hydrogen gas processing at a temperature of 1200 °C. At that time, a temperature precision of $\pm$ 1 °C is required, so the cost for planarization of a substrate of large diameter is very high.

To solve this problem, according to the fourth embodiment of the present invention, the substrate processing apparatus 10 or 20 in FIG. 1 or in FIG. 12, respectively, are used, the temperature of the substrate 13 is set to 800 °C, and a processing gas containing hydrogen gas and inactive gases is fed to the inside of the processing chamber 11 from the gas line 11.

The hydrogen gas content in the processing gas fed in this way is converted into hydrogen radicals H* when passing through the catalytic filter 15, acts on the surface of the substrate 13, and the projecting portions on the substrate surface are planarized while emitting $SiH_4$ gas as the reaction product. In this case, because it is not the hydrogen molecules $H_2$ but the hydrogen radicals H* that are used as the reactants, the planarizing reaction proceeds efficiently even at a temperature as low as 800 °C.

### [Fifth Embodiment]

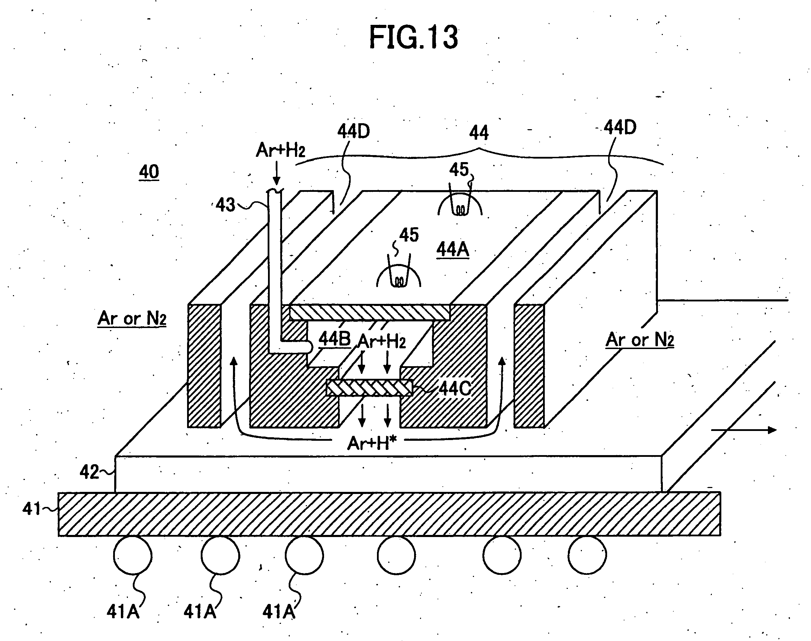

FIG. 13 shows a configuration of a substrate processing apparatus 40 according to the fifth embodiment of the present invention.

Referring to FIG. 13, the substrate processing apparatus 40 is equipped with a substrate conveying path 41 that extends to the atmosphere and is driven by a driving device 41A. A glass substrate 42 formed with a TFT or others is conveyed as a substrate to be processed on the substrate conveying path 41 along the direction of the arrow. In the state in FIG. 13, the glass substrate 42 is located in a processing space occupied by Ar or nitrogen or other inactive gases in the atmospheric environment, and the inactive gases fill up in processing space. Note that in the processing space, atmospheric content (air) is eliminated.

In the processing space, a processing head 44 is provided, to which a processing gas containing hydrogen gas and Ar gas is supplied via a gas line 43 from an external gas source. In the processing head 44, the processing gas stays for a while in the processing gas space 44B whose upper end and lower end are served by the silica window 44A and the hydrogen catalytic filter 44C, respectively. Further, in the processing head 44, a pair of exhaust ports 44D are formed outside the processing gas space 44B. The hydrogen catalytic filter 44C may have any of configurations as shown above in FIGs. 2A and 2B, or FIGs. 10A and 10B, or even FIG. 11.

In the configuration in FIG. 13, by exhausting through the exhaust port 44D, in the processing head 44, a gas flow of the processing gas is formed to flow from the processing gas space 44B to the exhaust ports 44D along the surface of the substrate 42 through the catalytic filter 44C. When the processing gas passes through the hydrogen catalytic filter 44C, the hydrogen molecules are decomposed into hydrogen radicals H*, and the generated hydrogen radicals H* are conveyed to the surface of the substrate 42 along the flow of the processing gas, and are discharged at the exhaust ports 44D.

Therefore, by heating the substrate 42 with the lamp 45 arranged outside the silica window 44A, the surface of the substrate 42 can be treated by the hydrogen radicals H*.

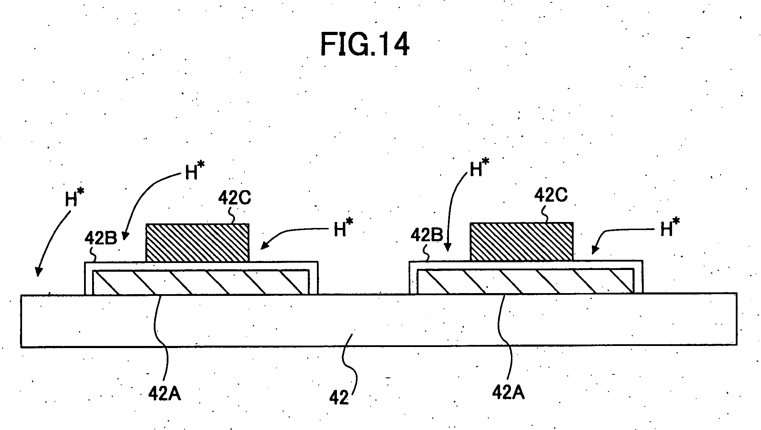

FIG. 14 shows an enlarged view of the surface of the substrate 42.

Making reference to FIG. 14, on the surface of the glass substrate 42, for each TFT, there are formed active region patterns 42A from poly-silicon or amorphous silicon. The surface of an active region pattern 42A is covered by a gate insulating film 42B comprised of a nitride film or a nitride oxide film. Further, a gate electrode 42C is formed on the active region pattern 42A with the gate insulating film 42B in between.

Accordingly, with the configuration in FIG. 13, by supplying hydrogen radicals H* to the surface of the glass substrate 42, it is possible to effectively terminate the dangling bonds existing in the active region pattern 42A or in the interfacial region between the active region pattern 42A and the gate insulating film 42B.

In the configuration in FIG. 13, the glass substrate 42 is moved along the conveying path 41, thereby the processing head 44 scans the surface of the glass substrate, and as a result, effective treatment is possible even if the area of the glass substrate is large. Of course, the glass substrate 42 may instead be fixed, in which case the processing head 44 moves together with the processing space.

Furthermore, if necessary, it is also possible to rotate the glass substrate 42.

While the invention has been described with reference to preferred embodiments, the invention is not limited to these embodiments, but numerous modifications could be made thereto without departing from the basic concept and scope described in the claims.

INDUSTRY APPLICABILITY

According to the present invention, by generating hydrogen radicals H* from hydrogen gas using a catalytic filter, even if a fine insulating film such as a nitride film or a nitride oxide film is formed on the surface of a semiconductor substrate, it is still possible to effectively terminate dangling bonds on the interface between the substrate and the insulating film. In this case, as in the present invention, by setting the catalytic filter in the proximity of the processed substrate, and further by supplying hydrogen gas diluted by inactive gases, the lifetime of the hydrogen radicals H*, accordingly the distance reachable by the hydrogen radicals H*, can be maximized. Further, as in the present invention, by using the hydrogen radicals H*, it is possible to perform planarization of a semiconductor substrate at a lower temperature. In the present invention, by providing a diffusion barrier film comprised of nitrides such as TiN, TaN, or WN between a metal catalytic layer comprised of catalytic metals exhibiting catalysis, and a carrier for holding the metal catalytic layer, it is possible to suppress diffusion of the above catalytic metal elements from the metal catalytic layer to the carrier, and diffusion of metal elements from the carrier to the metal catalytic layer, even if the catalytic reaction is carried out in an atmosphere including oxygen in addition to hydrogen, and thus it is possible to realize stable catalytic reactions.

**Claims**

1. A substrate processing apparatus (10), comprising:

   a processing space (11) provided with a holding stand (12) for holding a substrate (13) to be processed;
   a hydrogen catalyzing member (15, 25, 35, 44C) arranged in said processing space (11) to face said substrate (13) and for decomposing hydrogen molecules into hydrogen radicals H*; and
   a gas feeding port (11B) arranged in said processing space on an opposite side of the hydrogen catalyzing member (15) to said substrate (13) and for feeding a processing gas including at least hydrogen gas, **characterized in that** an interval between said hydrogen catalyzing member (15, 25, 35, 44C) and said substrate on said holding stand is set less than 60 mm, **in that** said hydrogen catalyzing member (15, 25, 35, 44C) comprises a carrier for carrying said catalyst, and **in that** the catalyst is provided on the carrier with a diffusion barrier film in between.

2. The substrate processing apparatus (10) according to claim 1, wherein an exhaust port (11A) is further provided in said processing space (11) on an opposite side of said substrate (13) to said hydrogen catalyzing member (15, 25, 35, 44C).

3. The substrate processing apparatus (10) according to claim 1 or 2, wherein said hydrogen catalyzing member (15, 25, 35, 44C) comprises a catalyst comprising one of a metal and a compound of a metal selected from a group including Ni, Pt, Pd, Ir, Au, and their alloys.

4. The substrate processing apparatus (10) according to one of the preceding claims, wherein said diffusion barrier film includes nitride.

5. The substrate processing apparatus according to claim 4, wherein said nitride is any one selected from TiN, TaN, and WN.

**6.** The substrate processing apparatus according to one of the preceding claims, wherein said hydrogen catalyzing member (15) includes a filter formed from a porous backing material, and a surface of the porous backing material is covered with said catalyst.

**7.** The substrate processing apparatus according to claim 6, wherein said porous backing material is formed from sintered metallic wires, and surfaces of the metallic wires are coated with said catalyst.

**8.** The substrate processing apparatus according to one of claims 1 to 5, wherein said hydrogen catalyzing member (25) includes a plate-shaped member ($15A_1$) and a plurality of penetration holes ($15B_1$) formed in said plate-shaped member, and at least an inner surface of each said penetration hole ($15B_1$) is covered with said catalyst.

**9.** The substrate processing apparatus according to claim 8, wherein a member is inserted into each said penetration hole ($15B_1$) for forming a gas flowing path between said inner surface and said member, and a gas flow diffusing portion is formed at an end of said member.

**10.** The substrate processing apparatus according to one of claims 1 to 5, wherein said hydrogen catalyzing member (35) comprises a stacked structure of a plurality of catalytic layers (35A, 35B, 35C), each of the catalytic layer being formed from a plate-shaped member, a plurality of penetration holes being formed in said plate-shaped member, and at least an inner surface of each of the penetration holes being covered with said catalyst.

**11.** The substrate processing apparatus according to one of the preceding claims, wherein said hydrogen catalyzing member (15, 25, 35, 44C) includes a temperature controlling means.

**12.** The substrate processing apparatus (10) according to one of the preceding claims, wherein said hydrogen catalyzing member (15, 25, 35, 44C) is arranged to be substantially parallel with said substrate (13) on said holding stand (12).

**13.** The substrate processing apparatus (10) according to one of the preceding claims, wherein said hydrogen catalyzing member(15, 25, 35, 44C) is of a size able to cover the entire surface of said substrate (13) on said holding stand (12).

**14.** The substrate processing apparatus (10) according to one of the preceding claims, wherein a moving device (41) is further provided for moving said hydrogen catalyzing member (44C) and said holding stand (12) relative to each other.

**15.** The substrate processing apparatus (10, 20, 40) according to claim 14, wherein said moving device (41) is adapted to move said holding stand while keeping said holding stand in parallel with said hydrogen catalyzing member (44C).

**16.** The substrate processing apparatus (10, 20, 40) according to one of the preceding claims, wherein said processing space (11) is a region adapted to be filled with an atmosphere of inactive gas.

**17.** The substrate processing apparatus according to one of the preceding claims, wherein said processing space is formed in a chamber defined by its sidewall.

**18.** The substrate processing apparatus (10, 20, 40) according to one of the preceding claims, further being adapted to feed said hydrogen gas from said gas feeding port (11B) to said processing chamber (11) in a state diluted by a carrier gas.

**19.** The substrate processing apparatus (10, 20, 40) according to one of the preceding claims, wherein said processing chamber (11) includes a light transmission window (11W), and a lamp heat source (14) is provided outside of said processing chamber (11) corresponding to said light transmission window.

**20.** The substrate processing apparatus (10, 20, 40) according to one of the preceding claims, wherein said holding stand (12) includes a heating device.

**21.** A substrate processing method, comprising:

a step of feeding hydrogen gas as a processing gas to a processing chamber (11);
a step of activating said hydrogen gas with a hydrogen catalyst (15, 25, 35, 44C), said hydrogen catalyst (15, 25, 35, 44C) comprising a carrier for carrying said catalyst, said catalyst being provided on the carrier with a diffusion barrier film in between, and generating hydrogen radicals H*;
a step of making said hydrogen radicals H* flow to a substrate (13) to be processed; and
a step of processing said substrate using said hydrogen radicals H*.

**22.** The substrate processing method according to claim 21, wherein said processing gas includes said hydrogen gas diluted by inactive gas.

**23.** The substrate processing method according to claim 21 or 22, wherein said processing gas includes said hydrogen gas at a concentration of not more than 1 %.

**24.** The substrate processing method according to one of claims 21 to 23, wherein said substrate (13) is a silicon substrate carrying an insulating film, the step using said hydrogen radicals H* includes a step of terminating dangling bonds existing on the interface between said silicon substrate and said insulating film.

25. The substrate processing method according to claims 21 to 23, wherein said substrate is a glass substrate, the step using said hydrogen radicals H* includes a step of terminating dangling bonds existing in one of a poly-silicon film and an amorphous silicon film on a surface of said glass substrate, and dangling bonds existing in an insulating film.

26. The substrate processing method according to one of claims 21 to 25, wherein the step of generating hydrogen radicals H* is carried out at a temperature not lower than 100°C.

27. The substrate processing method according to one of claims 21 to 26, wherein in the step using said hydrogen radicals H*, an amount of said hydrogen radicals H* in response to an atomic area density of said substrate is supplied to said substrate.

28. The substrate processing method of claim 21 wherein said step of processing is a step of planarizing said substrate using said hydrogen radicals H*, and

wherein the step of planarizing said substrate is carried out at a temperature not higher than 800°C.

**Patentansprüche**

1. Substratbearbeitungsvorrichtung (10) mit:

einem Bearbeitungsraum (11), der eine Haltevorrichtung (12) zur Aufnahme eines zu bearbeitenden Substrates (13) umfasst; einer Wasserstoff-Katalysator-Einheit (15, 25, 35, 44C), die in dem Bearbeitungsraum (11) dem Substrat (13) gegenüberliegend angeordnet ist, zum Zerlegen von Wasserstoff-Molekülen in Wasserstoff Radikale H*; und einem Gaszufuhranschluss (11B), der in dem Bearbeitungsraum (11) auf einer von dem Substrat (13) abgewandten Seite der Wasserstoff-Katalysator-Einheit (15) angeordnet ist, zum Zuführen eines Bearbeitungsgases, das zumindest Wasserstoffgas enthält, **dadurch gekennzeichnet, dass** ein Zwischenraum zwischen der Wasserstoff-Katalysator-Einheit (15, 25, 35, 44C) und dem Substrat (13) auf der Trägereinheit (12) auf weniger als 60 mm eingestellt ist, die Wasserstoff-Katalysator-Einheit (15, 25, 35, 44C) einen Träger zum Tragen des Katalysators umfasst und dass der Katalysator auf dem Träger mit einem dazwischen liegenden Diffusionssperrfilm angeordnet ist.

2. Substratbearbeitungsvorrichtung (10) nach Anspruch 1, wobei zusätzlich ein Auslassanschluss (11A) in dem Bearbeitungsraum (11) an einer von der Wasserstoff-Katalysator-Einheit (15, 25, 35, 44C) abgewandten Seite des Substrats (13) angeordnet ist.

3. Substratbearbeitungsvorrichtung (10) nach Anspruch 1 oder 2, wobei die Wasserstoff-Katalysator-Einheit (15, 25, 35, 44C) einen Katalysator umfasst, der ein Metall oder eine Metallverbindung beinhaltet, die aus einer Ni, Pt, Pd, Ir, Au und ihre Legierungen umfassenden Gruppe gewählt ist.

4. Substratbearbeitungsvorrichtung (10) nach einem der vorangehenden Ansprüche, wobei der Diffusionssperrfilm ein Nitrid enthält.

5. Substratbearbeitungsvornchtung nach Anspruch 4, wobei das Nitrid unter TiN, TaN und WN gewählt ist.

6. Substratbearbeitungsvorrichtung nach einem der vorangehenden Ansprüche, wobei die Wasserstoff-Katalysator-Einheit (15) einen aus einem porösen Grundmaterial geformten Filter umfasst und eine Oberfläche des porösen Grundmaterials mit dem Katalysator bedeckt ist.

7. Substratbearbeitungsvorrichtung nach Anspruch 6, wobei das poröse Grundmaterial aus gesinterten metallischen Drähten gebildet ist und Oberflächen der metallischen Drähte mit dem Katalysator beschichtet sind.

8. Substratbearbeitungsvorrichtung nach einem der Ansprüche 1 bis 5, wobei die Wasserstoff-Katalysator-Einheit (25) ein plattenförmiges Element ($15A_1$) und mehrere in dem plattenförmigen Element ausgebildete Durchgangslöcher ($15B_1$) umfasst und wobei zumindest eine innere Oberfläche jedes Durchgangsloches ($15B_1$) mit dem Katalysator bedeckt ist.

9. Substratbearbeitungsvorrichtung nach Anspruch 8, wobei ein Körper in jedes Durchgangsloch ($15B_1$) eingesetzt ist zur Ausformung eines Gasströmungswegs zwischen der inneren Oberfläche und dem Körper und wobei ein Gasströmungsdiffusionsabschnitt an einem Ende des Körpers ausgeformt ist.

10. Substratbearbeitungsvorrichtung nach einem der Ansprüche 1 bis 5, wobei die Wasserstoff-Katalysator-Einheit (35) eine geschichtete Anordnung mehrerer katalytischer Schichten (35A, 35B, 35C) umfasst, wobei jede der katalytischen Schichten aus einem plattenförmigen Element geformt ist, in dem plattenförmigen Element mehrere Durchgangslöcher ausgeformt sind und wenigstens eine innere Oberfläche jedes der Durchgangslöcher mit dem Katalysator bedeckt ist.

11. Substratbearbeitungsvorrichtung nach einem der vorangehenden Ansprüche, wobei die Wasserstoff-Katalysator-Einheit (15, 25, 35, 44C) Mittel zur Temperatursteuerung umfasst.

12. Substratbearbeitungsvornchtung (10) nach einem der vorangehenden Ansprüche, wobei die Wasserstoff-Katalysator-Einheit (15, 25, 35, 44C) im Wesentlichen parallel zu dem Substrat (13) auf der Haltevorrichtung (12) angeordnet ist.

13. Substratbearbeitungsvorrichtung (10) nach einem der vorangehenden Ansprüche, wobei die Wasserstoff-Katalysator-Einheit (15, 25, 35, 44C) von hinreichender Größe ist, um die gesamte Oberfläche des Substrats (13) auf der Haltevorrichtung (12) zu überdecken.

14. Substratbearbeitungsvorrichtung (10) nach einem der vorangehenden Ansprüche mit zusätzlich einer Bewegungseinheit (41) zum Bewegen der Wasserstoff-Katalysator-Einheit (44C) und der Haltevorrichtung (12) relativ zueinander.

15. Substratbearbeitungsvorrichtung (10, 20, 40) nach Anspruch 14, wobei die Bewegungseinheit (41) dazu eingerichtet ist, die Haltevorrichtung (12) zu bewegen und dabei die Haltevorrichtung (12) parallel zur Wasserstoff-Katalysator-Einheit (44C) zu halten.

16. Substratbearbeitungsvorrichtung (10, 20, 40) nach einem der vorangehenden Ansprüche, wobei der Bearbeitungsraum (11) ein zum Befüllen mit einer Atmosphäre eines inaktiven Gases eingerichtetes Raumgebiet ist.

17. Substratbearbeitungsvorrichtung nach einem der vorangehenden Ansprüche, wobei der Bearbeitungsraum in einer durch ihre Seitenwand umgrenzten Kammer ausgebildet ist.

18. Substratbearbeitungsvorrichtung (10, 20, 40) nach einem der vorangehenden Ansprüche, die zusätzlich dazu eingerichtet ist, das Wasserstoffgas vom Gaszufuhranschluss (11B) zu der Bearbeitungskammer (11) in einem durch ein Trägergas verdünnten Zustand zuzuleiten.

19. Substratbearbeitungsvorrichtung (10, 20, 40) nach einem der vorangehenden Ansprüche, wobei die Bearbeitungskammer (11) ein Lichtdurchgangsfenster (11W) umfasst und außerhalb der Bearbeitungskammer (11) entsprechend dem Lichtdurchgangsfenster eine Lampenwärmequelle (14) eingerichtet ist.

20. Substratbearbeitungsvorrichtung (10, 20, 40) nach einem der vorangehenden Ansprüche, wobei die Haltevorrichtung (12) eine Heizeinheit umfasst.

21. Substratbearbeitungsverfahren mit folgenden Schritten:

Zuführen von Wasserstoffgas als ein Bearbeitungsgas in eine Bearbeitungskammer (11);
Aktivieren des Wasserstoffgases mittels eines Wasserstoff-Katalysators (15, 25, 35, 44C), wobei der Wasserstoff-Katalysator (15, 25, 35, 44C) einen Träger zum Tragen des Katalysators umfasst und der Katalysator auf dem Träger mit einem dazwischen liegenden Diffusionssperrfilm angeordnet ist, und Erzeugen von Wasserstoff-Radikalen H*;
Veranlassen der Wasserstoff-Radikale H*, zu einem zu bearbeitenden Substrat (13) zu strömen; und
Bearbeiten des Substrats unter Verwendung der Wasserstoff-Radikale H*.

22. Substratbearbeitungsverfahren nach Anspruch 21, wobei das Bearbeitungsgas das durch ein inaktives Gas verdünnte Wasserstoffgas beinhaltet.

23. Substratbearbeitungsverfahren nach Anspruch 21 oder 22, wobei das Bearbeitungsgas das Wasserstoffgas in einer Konzentration von nicht über 1 % enthält.

24. Substratbearbeitungsverfahren nach einem der Ansprüche 21 bis 23, wobei das Substrat (13) ein eine isolierende Schicht tragendes Silizium-Substrat ist und der Schritt der Verwendung der Wasserstoff-Radikale H* einen Schritt des Abbindens von an der Trennfläche zwischen dem Silizium-Substrat und der isolierenden Schicht vorliegenden freien Bindungen umfasst.

25. Substratbearbeitungsverfahren nach einem der Ansprüche 21 bis 23, wobei das Substrat ein Glassubstrat ist und der Schritt der Verwendung der Wasserstoff-Radikale H* einen Schritt des Abbindens freier Bindungen umfasst, die in einer Polysilizium-Schicht oder einer amorphen Siliziumschicht auf der Oberfläche des Glassubstrats sowie in einer isolierenden Schicht vorliegen.

26. Substratbearbeitungsverfahren nach einem der Ansprüche 21 bis 25, wobei der Schritt der Erzeugung von Wasserstoff-Radikalen H* bei einer Temperatur von nicht unter 100°C ausgeführt wird.

27. Substratbearbeitungsverfahren nach einem der Ansprüche 21 bis 26, wobei in dem Schritt der Verwendung der Wasserstoff-Radikale H* dem Substrat in Abhängigkeit von einer atomaren Flächendichte des Substrats eine Menge von Wasserstoff-Radikalen H* zugeführt wird.

28. Substratbearbeitungsverfahren nach Anspruch 21, wobei der Schritt des Bearbeitens ein Schritt der Ebnung des Substrats unter Verwendung der Wasserstoff-Radikale H* ist und wobei der Schritt der Ebnung des Substrats bei einer Temperatur von nicht über 800°C ausgeführt wird.

**Revendications**

1. Dispositif de traitement de substrat (10), comprenant:

   un espace de traitement (11) muni d'un support (12) pour maintenir un substrat (13) à traiter ; un élément catalysant l'hydrogène (15, 25, 35, 44C) disposé dans l'espace de traitement (11) pour faire face au substrat (13) et pour décomposer des molécules d'hydrogène en radicaux hydrogène H*; et un accès de fourniture de gaz (11B) disposé dans l'espace de traitement du côté opposé à l'élément catalysant l'hydrogène (15) par rapport au substrat (13) et pour fournir un gaz de traitement incluant au moins de l'hydrogène,

   **caractérisé en ce que** l'intervalle entre l'élément catalysant l'hydrogène (15, 25, 35, 44C) et le substrat sur le support est fixé inférieur à 60 mm, **en ce que** l'élément catalysant l'hydrogène (15, 25, 35, 44C) comprend un support pour porter le catalyseur, et **en ce que** le catalyseur est fourni sur le support avec interposition d'une couche barrière de diffusion.

2. Dispositif de traitement de substrat (10) selon la revendication 1, dans lequel un accès de sortie (11A) est prévu dans l'espace de traitement (11) du côté opposé ou substrat (13) par rapport à l'élément catalysant l'hydrogène (15, 25, 35, 44C).

3. Dispositif de traitement de substrat (10) selon la revendication 1 ou 2, dans lequel l'élément catalysant l'hydrogène (15, 25, 35, 44C) comprend un catalyseur comprenant l'un d'un métal et d'un composé d'un métal choisi dans le groupe comprenant Ni, Pt, Pd, Ir, Au, et leurs alliages.

4. Dispositif de traitement de substrat (10) selon l'une quelconque des revendications précédentes, dans lequel la couche barrière de diffusion inclut un nitrure.

5. Dispositif de traitement de substrat selon la revendication 4, dans lequel le nitrure est choisi parmi TiN, TaN et WN.

6. Dispositif de traitement de substrat selon l'une quelconque des revendications précédentes, dans lequel l'élément catalysant l'hydrogène (15) inclut un filtre constitué d'un matériau support poreux et une surface du matériau support poreux est recouverte du catalyseur.

7. Dispositif de traitement de substrat selon la revendication 6, dans lequel le matériau support poreux est constitué de fils métalliques frittés et les surfaces des fils métalliques sont revêtus du catalyseur.

8. Dispositif de traitement de substrat selon l'une quelconque des revendications 1 à 5, dans lequel l'élément catalysant l'hydrogène (25) inclut un élément en forme de plaque ($15A_1$) et une pluralité de trous de pénétration ($15B_1$) formés dans l'élément en forme de plaque, au moins la surface interne de chaque trou de pénétration ($15B_1$) étant recouverte du catalyseur.

9. Dispositif de traitement de substrat selon la revendication 8, dans lequel un élément est inséré dans chaque trou de pénétration ($15B_1$) pour former un trajet d'écoulement de gaz entre la surface interne de l'élément, et une partie de diffusion d'écoulement de gaz est formée à une extrémité dudit élément.

10. Dispositif de traitement de substrat selon l'une quelconque des revendications 1 à 5, dans lequel l'élément catalysant l'hydrogène (35) comprend une structure empilée d'une pluralité de couches catalytiques (35A, 35B, 35C), chacune des couches catalytiques étant constituée d'un élément en forme de plaque, une pluralité de trous de pénétration étant formée dans l'élément en forme de plaque et au moins la surface interne de chacun des trous de pénétration étant recouverte du catalyseur.

11. Dispositif de traitement de substrat selon l'une quelconque des revendications précédentes, dans lequel l'élément catalysant l'hydrogène (15, 25, 35, 44C) inclut un moyen de contrôle de température.

12. Dispositif de traitement de substrat (10) selon l'une quelconque des revendications précédentes, dans lequel l'élément catalysant l'hydrogène (15, 25, 35, 44C) est prévu pour être sensiblement en parallèle au substrat (13) sur le support (12).

**13.** Dispositif de traitement de substrat (10) selon l'une quelconque des revendications précédentes, dans lequel l'élément catalysant l'hydrogène (15, 25, 35, 44C) est d'une dimension apte à recouvrir toute la surface du substrat (13) sur le support (12).

**14.** Dispositif de traitement de substrat (10) selon l'une quelconque des revendications précédentes, dans lequel un dispositif de déplacement (41) est en outre prévu pour déplacer l'élément catalysant l'hydrogène (44C) et le support (12) l'un par rapport à l'autre.

**15.** Dispositif de traitement de substrat (10, 20, 40) selon la revendication 14, dans lequel le dispositif de déplacement (41) est apte à déplacer le support tout en maintenant le support parallèle à l'élément catalysant l'hydrogène (44C).

**16.** Dispositif de traitement de substrat (10, 20, 40) selon l'une quelconque des revendications précédentes, dans lequel l'espace de traitement (11) est une région adaptée à être remplie d'une atmosphère de gaz inactif.

**17.** Dispositif de traitement de substrat selon l'une quelconque des revendications précédentes, dans lequel l'espace de traitement est formé dans une chambre définie par sa paroi latérale.

**18.** Dispositif de traitement de substrat (10, 20, 40) selon l'une quelconque des revendications précédentes, adapté en outre à fournir l'hydrogène gazeux à partir de l'accès de fourniture de gaz (11B) vers la chambre de traitement (11) dans un état dilué par un gaz porteur.

**19.** Dispositif de traitement de substrat (10, 20, 40) selon l'une quelconque des revendications précédentes, dans lequel la chambre de traitement (11) inclut une fenêtre de transmission de lumière (11W) et une source de chaleur à lampe (14) est prévue en dehors de la chambre de traitement (11) en face de la fenêtre de transmission de lumière.

**20.** Dispositif de traitement de substrat (10, 20, 40) selon l'une quelconque des revendications précédentes, dans lequel le support (12) inclut un dispositif chauffant.

**21.** Procédé de traitement de substrat comprenant :

une étape de fourniture d'hydrogène en tant que gaz de traitement à une chambre de traitement (11);
une étape d'activation de l'hydrogène par un catalyseur d'hydrogène (15, 25, 35, 44C), le catalyseur d'hydrogène (15, 25, 35, 44C) comprenant un support pour porter le catalyseur, le catalyseur étant fourni sur le support avec une barrière de diffusion intercalée, et produisant des radicaux hydrogène H*;
une étape consistant à amener les radicaux hydrogène H* à s'écouler vers un substrat (13) à traiter; et
une étape de traitement du substrat en utilisant les radicaux hydrogène H*.

**22.** Procédé de traitement de substrat selon la revendication 21, dans lequel le gaz de traitement inclut de l'hydrogène dilué dans un gaz inactif.

**23.** Procédé de traitement de substrat selon la revendication 21 ou 22, dans lequel le gaz de traitement inclut de l'hydrogène à une concentration non supérieure à 1 %.

**24.** Procédé de traitement de substrat selon l'une quelconque des revendications 21 à 23, dans lequel le substrat (13) est un substrat de silicium portant une couche isolante, l'étape utilisant les radicaux hydrogène H* incluant une étape de fermeture de liaison ouverte existant à l'interface du substrat de silicium et de la couche isolante.

**25.** Procédé de traitement de substrat selon l'une quelconque des revendications 21 à 23, dans lequel le substrat est un substrat de verre, l'étape d'utilisation des radicaux hydrogène H* inclut une étape de terminaison des liaisons ouvertes existant dans une couche de silicium polycristallin ou une couche de silicium amorphe à la surface du substrat de verre, des liaisons ouvertes existant dans une couche isolante.

**26.** Procédé de traitement de substrat selon l'une quelconque des revendications 21 à 25, dans lequel l'étape de génération de radicaux hydrogène H* était effectuée à une température non inférieure à 100°C.

**27.** Procédé de traitement de substrat selon l'une quelconque des revendications 21 à 26, dans lequel, lors de l'étape d'utilisation des radicaux hydrogène H*, une quantité de radicaux hydrogène H* en réponse à la densité atomique de surface du substrat est fournie au substrat.

**28.** Procédé de traitement de substrat selon la revendication 21, dans lequel:

l'étape de traitement est une étape de planarisation du substrat en utilisant les radicaux hydrogène H*, et
l'étape de planarisation du substrat est effectuée à une température non supérieure à 800°C.

**FIG.1**

## FIG.2A

15

15H  15B  H₂  15H  H₂  15A  H₂

H* H* H H* 

13

## FIG.2B

# FIG.3

## FIG.4

## FIG.5

FIG.6

# FIG.7

EP 1 403 913 B1

# FIG.8

# FIG.9

EP 1 403 913 B1

# FIG.10A

# FIG.10B

# FIG.11

# FIG.12

EP 1 403 913 B1

# FIG.13

EP 1 403 913 B1

# FIG.14

EP 1 403 913 B1

**EP 1 403 913 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000216165 A

- JP 2000031109 A